# EUROPEAN PATENT APPLICATION

(11) **EP 1 729 233 A2**
(43) Date of publication of application: **06.12.2006**
(21) Application number: 06010848.7
(22) Date of filing: 26.05.2006
(51) Int. Cl.: G06F 17/50

(54) **CAD method, CAD system and program storage medium storing CAD program thereof**

(30) Priority: 30.05.2005 JP 2005157857
(71) Applicant: FUJITSU LIMITED, Kawasaki-shi, Kanagawa 211-8588 (JP)
(72) Inventor: Onoue, Takuya, Sawara-ku Fukuoka-shi Fukuoka 814-8589 (JP); Tosu, Masaharu, Atsugi-shi Kanagawa 243-0018 (JP); Tomomitsu, Noboru, Atsugi-shi Kanagawa 243-0018 (JP); Takeuchi, Hiroharu, Yokohama-shi Kanagawa-ken 220 8623 (JP); Mori, Masatsugu, Yokohama-shi Kanagawa-ken 220 8623 (JP)
(74) Representative: Sunderland, James Harry

(57) **Abstract**

The CAD system includes primary-geometric data extraction means for extracting primary geometric data from a CAD object selected; primary-geometric-condition determination means for deriving a geometric condition from the primary geometric data; automatic recognition means for performing automatic recognition of a CAD object that satisfies the geometric condition with respect to the selected CAD object; secondary-geometric data extraction means which extracts secondary geometric data from the additionally selected CAD object; and secondary-geometric-condition determination means for deriving a geometric condition from the secondary geometric data. The automatic recognition means performs automatic recognition of a CAD object that satisfies the geometric condition derived by the secondary-geometric-condition determination means with respect to the first selected CAD object, the automatically recognized CAD object that satisfies the first derived geometric condition, and the additionally selected CAD object.

## Description

### BACKGROUND OF THE INVENTION

### 1. Field of the Invention

The present invention relates to a computer-aided design (CAD) system, in particular to a CAD system that facilitates selection of geometric shapes constituting a three-dimensional model existing in a virtual three-dimensional coordinate space.

### 2. Description of the Related Art

There are three types of three-dimensional models classified according to modeling technique: the wire-frame model, the surface model, and the solid model. The wire-frame model includes only vertices and edges connecting the vertices; it does not have data of surfaces. The surface model is represented by adding data of surfaces to the wire-frame model. The solid model includes data of vertices, edges, surfaces, mass, etc. to represent geometric shape close to that of a real-world entity.

The wire-frame model includes geometric data of vertex coordinates and edges. The wire-frame model includes graphical elements such as points, straight lines and line segments, circles and arcs, ellipses and elliptic arcs, conic sections, free-form curves, etc.

The surface model includes data of surfaces in addition to vertex coordinates and edges. The surface model includes graphical elements such as normal planes, cylindrical surfaces, conical surfaces, torus surfaces, spherical surfaces, and free-form surfaces.

The solid model includes data of surface directions in addition to vertex coordinates, edges, and surfaces. Methods for representing the solid model include CSG (Constructive Solid Geometry), B-reps (Boundary Representation), Voxel, Octree, Sweep representation, etc. The CSG represents a solid by combining primitives such as a cube, a prism, a sphere, an ellipse, a cone, a pyramid, etc. In the B-reps, a solid is represented by phase elements indicating how graphical elements such as a vertex, an edge, a loop, and a surface, are linked and geometric elements indicating the geometric shapes of elements such as a surface, a line (including a curved line), and a point. The Voxel represents a solid as a collection of small cubes. In the Octree, the process of dividing a space into eight subspaces along the longitudinal, lateral, and vertical directions is repeated recursively until a state of whether or not a solid is completely contained in each subspace is established. In the Sweep representation, a solid is defined by translating and/or rotating a plane figure.

In order to form a solid object on a three-dimensional CAD system, a user is able not only to combine primitives but also to carry out extrusion, rotation, lofting (skinning), and sweeping. Editing operations on a solid object include chamfering, filleting, shelling, offsetting, shifting, scaling, etc.

Curves can be generated as follows. For a free-form curve, two or more any control points are designated and interpolation is performed in order of designation. For a composite curve, one curve is generated from two curves on different planes. For a connected line, a curve connecting end points of two existing curves is generated. A projection line is generated by projecting an existing geometric element onto a designated surface in a designated direction. A borderline is generated by extracting a boundary of a solid model or a curved surface. For a line of intersection, a line of intersection along a portion where surfaces intersect is generated.

Curved surfaces can be generated as follows. For extrusion, the locus obtained by translating a sectional line in a designated direction is generated as a curved surface. For rotation, the locus obtained by rotating a sectional line around an axis is generated as a curved surface. For sweeping, the locus obtained by translating a sectional line along a sweep path is generated as a curved surface. For ruled, a curved surface is generated by associating corresponding points on two lines and connecting them with line segments. For a boundary, a curved surface having a designated line as a boundary is generated. For lofting, a curved surface is generated by smoothly connecting a plurality of sectional lines. For meshing, a curved surface is generated from a group of lines forming a lattice shape. For offsetting, a curved surface is generated by offsetting a curved surface in a designated direction.

Curved surfaces can be edited as follows. For cutting, a curved surface is cut along any line or curved surface. For joining, a plurality of curved surfaces sharing a border line is joined. For extension, a curved surface is extended by designating a length. For trimming, part of a curved surface is trimmed along a designated line or curved surface. For untrimming, the original curved surface is reconstructed from a trimmed curved surface. For inversion, the front and back sides of curved surfaces are inversed for consistent front or back surfaces.

For set operations between solid models and between a solid model and a surface model, the Boolean operation "sum", the Boolean operation "difference", the Boolean operation "product", cutting along a plane, cutting along another curved surface, etc. are available.

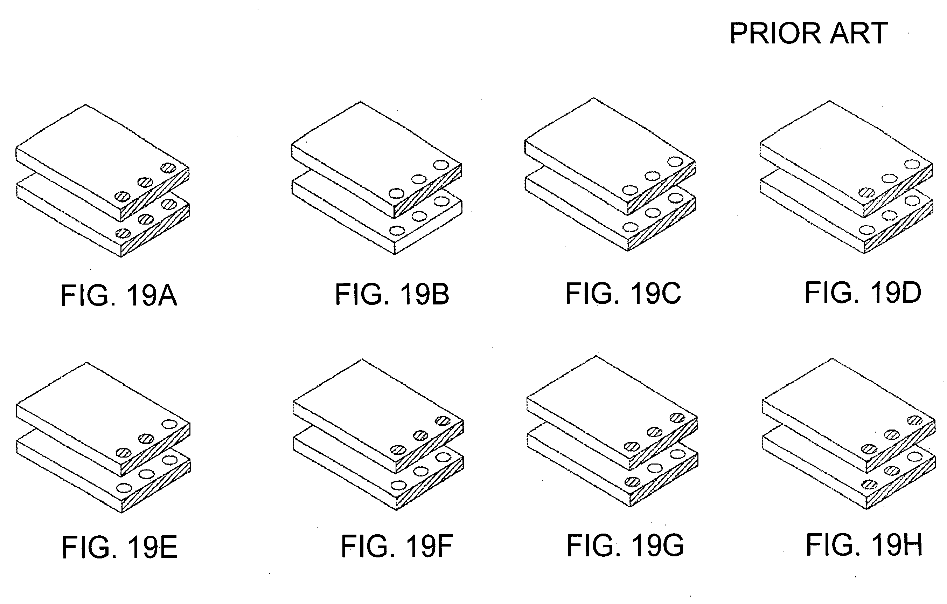

In order to perform these operations with known techniques, users would use input means such as a mouse to designate CAD objects such as a point, a line, a surface, a solid object, and a combination of solid objects, one at a time. More specifically, in order to designate two surfaces and six holes indicated by hatched lines in the three-dimensional model shown in Fig. 19A, the surface of the upper plate is designated first (refer to Fig. 19B). The surface of the lower plate is designated (refer to Fig. 19C). The left hole on the surface of the upper plate is designated (refer to Fig. 19D). The center hole on the surface of the upper plate is designated (refer to Fig. 19E). The right hole on the surface of the upper plate is designated (refer to Fig. 19F). The left hole on the surface of the lower plate is designated (refer to Fig. 19G). The center hole on the surface of the lower plate is designated (refer to Fig. 19H). The right hole on the surface of the lower plate is designated (refer to Fig. 19A). Therefore, the user needed to designate CÄD objects the same number of times as the CAD objects selected.

Since known three-dimensional CAD Systems have a structure as described above, the user needs to designate one CAD object at a time when selecting CAD objects. In recent three-dimensional models, which are increasingly large-scaled, this is problematic in that the user spends a substantial time designating desired CAD objects.

Furthermore, three-dimensional CAD systems require users to designate CAD objects while they refer to a working window with a certain display magnification from a certain viewpoint. This is also problematic in that some CAD objects are invisible or difficult to see from a certain viewpoint or with a certain display magnification, causing some CAD objects to be overlooked at the time of designation. Users may exercise care to designate CAD objects with a plurality of display magnifications and from a plurality of viewpoints to prevent CAD objects from being overlooked resulting from the above-described drawback. Although this may reduce the number of CAD objects to be overlooked, it poses another problem that the working efficiency is significantly decreased.

### SUMMARY OF THE INVENTION

The present invention has been conceived to solve the above-described problem, and an object of the present invention is to provide a three-dimensional CAD system that allows all CAD objects to be appropriately selected by requiring a user to designate only some CAD objects rather than designate all CAD objects to be selected.

A CAD method according to an aspect of the present invention allows a computer to execute a step of acquiring first geometric data of a first CAD object selected, a step of acquiring a first geometric condition on a basis of the first geometric data, and a step of acquiring a second CAD object, said second CAD object satisfying the first geometric condition with respect to the first CAD object. As described above, in the present invention, first geometric data is extracted from a first CAD object selected, a first geometric condition to be applied is derived from the first geometric data, and a second CAD object that satisfies the first geometric condition with respect to the first CAD object is automatically detected. When the user once designates a CAD object, a CAD object having a certain relationship with the designated CAD object is automatically detected, thus significantly reducing the workload of user's designating a CAD object.

The CAD method may allow the computer to execute a step of acquiring second geometric data of a third CAD object selected, a step of acquiring a second geometric condition on a basis of the first geometric data and the second geometric data, and a step of acquiring a forth CAD object, said forth CAD object satisfying the second geometric condition with respect to the first CAD object, the second CAD object and the third CAD object. As described above, in the present invention, second geometric data is extracted from a third CAD object additionally selected, a second geometric condition to be applied is derived from the first geometric data and the second geometric data, and a forth CAD object that satisfies the second geometric condition with respect to the first CAD object, the second CAD object, and the third CAD object is automatically recognized. Therefore, not only a CAD object having a certain relationship with one CAD object but also a CAD object having a certain relationship with one CAD object and another CAD object is automatically detected, thereby further reducing the workload of user's designating a CAD object.

A CAD system according to another aspect of the present invention includes a means for acquiring first geometric data of a first CAD object selected, a means for acquiring a first geometric condition on a basis of the first geometric data, and a means for acquiring a second CAD object, said second CAD object satisfying the first geometric condition with respect to the first CAD object.

The CAD system may include a means for acquiring second geometric data of a third CAD object selected, a means for acquiring a second geometric condition on a basis of the first geometric data and the second geometric data, and a means for acquiring a forth CAD object, said forth CAD object satisfying the second geometric condition with respect to the first CAD object, the second CAD object and the third CAD object.

A computer-readable program storage medium according to another aspect of the present invention stores a CAD program that allows a computer to execute a step of acquiring first geometric data of a first CAD object selected, a step of acquiring a first geometric condition on a basis of the first geometric data, and a step of acquiring a second CAD object, said second CAD object satisfying the first geometric condition with respect to the first CAD object.

The CAD program stored in the program storage medium may allow the computer to execute a step of acquiring second geometric data of a third CAD object selected, a step of acquiring a second geometric condition on a basis of the first geometric data and the second geometric data, and a step of acquiring a forth CAD object, said forth CAD object satisfying the second geometric condition with respect to the first CAD object, the second CAD object and the third CAD object.

The foregoing summary of the invention is not a list of features required for the present invention. A subcombination of these features can also constitute the invention.

### BRIEF DESCRIPTION OF THE DRAWINGS

Fig. 1 is a block diagram of the structure of a three-dimensional CAD system according to a first embodiment of the present invention.
Fig. 2 is a diagram showing the structure of a geometric-condition search table of a three-dimensional CAD system according to the first embodiment of the present invention.
Fig. 3 is one example of an operating window of a three-dimensional CAD system according to the first embodiment of the present invention.
Fig. 4 is a flowchart illustrating one example of processing flow for target recognition according to the first embodiment of the present invention.
Fig. 5 is a flowchart illustrating in more detail the flow of plane processing according to the first embodiment of the present invention.
Figs. 6A and 6B are detailed illustrations of surface match of a plane and distance match of a plane according to the first embodiment of the present invention.
Fig. 7 is a flowchart illustrating in more detail the flow of plane follow-up processing according to the first embodiment of the present invention.
Figs. 8A and 8B constitute a flowchart illustrating in more detail the flow of cylindrical surface processing according to the first embodiment of the present invention.
Figs. 9A and 9B are detailed illustrations of surface match of a cylindrical surface according to the first embodiment of the present invention.
Figs. 10A and 10B are detailed illustrations of link and axis match of a cylindrical surface according to the first embodiment of the present invention.
Figs. 11A and 11B are detailed illustrations of link and axis match of a cylindrical surface and distance match of a cylindrical surface according to the first embodiment of the present invention.
Fig. 12 is a flowchart illustrating in more detail the flow of cylindrical surface follow-up processing according to the first embodiment of the present invention.
Figs. 13A, 13B, 13C, 13D, 13E and 13F show a series of illustrations for display of surface match of a plane and distance match of a plane according to the first embodiment of the present invention.
Figs. 14A, 14B, 14C, 14D, 14E and 14F show a series of illustrations for display of surface match of a cylindrical surface and distance match of a cylindrical surface according to the first embodiment of the present invention.
Fig. 15 is a block diagram of the structure of a three-dimensional CAD system according to a second embodiment of the present invention.
Figs. 16A, 16B, 16C, 16D, 16E and 16F illustrate display of parametric registration according to the second embodiment of the present invention.
Figs. 17A, 17B, 17C, 17D and 17E illustrate display of parametric registration according to the second embodiment of the present invention.
Fig. 18 shows one example of a table structure used for parametric registration according to the second embodiment of the present invention.
Figs. 19A, 19B, 19C, 19D, 19E, 19F, 19G and 19H show a series of illustrations for selection of geometric shapes according to prior art.

### DESCRIPTION OF THE PREFERRED EMBODIMENTS

The present invention can be realized in many different embodiments. Therefore, the present invention should not be interpreted as limited to the following embodiments. The same components are denoted by the same reference numerals throughout the embodiments.

Although the description in each of the embodiments focuses mainly on a system, the present invention can be realized by a computer-executable program and method, as is apparent to those skilled in the art. In addition, the present invention can be realized as embodiments of hardware, software, or software and hardware. Programs can be recorded on any computer-readable medium, such as a hard disk, a CD-ROM, a DVD-ROM, an optical memory apparatus, and a magnetic storage apparatus. Furthermore, programs can be recorded on another computer over a network.

### First Embodiment of the Present Invention

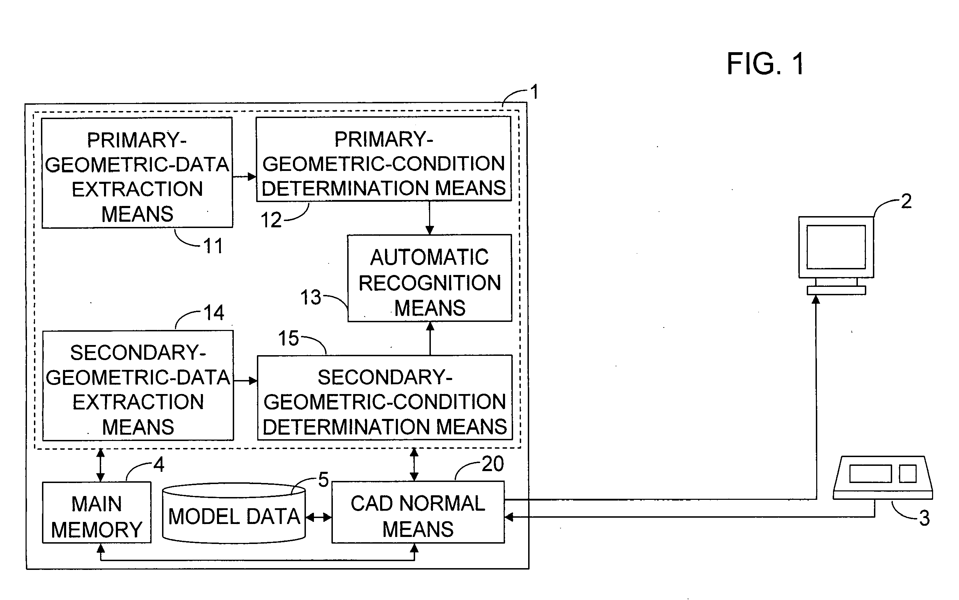

Embodiments of the present invention will now be described with reference to the drawings. Fig. 1 is a block diagram of the structure of a three-dimensional CAD system according to a first embodiment of the present invention. As shown in Fig. 1, the three-dimensional CAD system according to this embodiment includes primary-geometric data extraction means 11 for extracting primary geometric data from a geometric shape designated by a user; primary-geometric-condition determination means 12 for deriving a geometric condition from the primary geometric data; automatic recognition means 13 for performing automatic recognition (target recognition) of a geometric shape that satisfies the geometric condition with respect to the designated geometric shape; secondary-geometric data extraction means 14 which, when a geometric shape is additionally designated by the user, extracts secondary geometric data from the additionally designated geometric shape; and secondary-geometric-condition determination means 15 for deriving a geometric condition from the secondary geometric data. The three-dimensional CAD system according to this embodiment is characterized in that the automatic recognition means 13 performs automatic recognition (follow-up recognition) of a geometric shape that satisfies the geometric condition derived by the secondary-geometric-condition determination means 15 with respect to the first designated geometric shape, the automatically recognized geometric shape that satisfies the first derived geometric condition, and the additionally designated geometric shape. In addition to these features, the three-dimensional CAD system according to this embodiment includes CAD normal means 20 for providing normal functions of the three-dimensional CAD system, such as a function for drawing solid geometry of an object having a height, a width, and a depth in a virtual three-dimensional coordinate space and a function for receiving editing. The three-dimensional CAD system is built as a result of a three-dimensional CAD program being loadable into a computer. The computer includes a computer main unit 1 having a processor (e.g., CPU), a main memory 4, a hard disk 5, etc., a display unit serving as display means 2, a keyboard and a mouse serving as input means 3, and so on.

Geometric shapes include surfaces such as planes, cylindrical surfaces, and conical surfaces. Three-dimensional model data is a collection of elements constituting an object. Elements are a collection of primitives. Primitives are solids on three-dimensional CAD system, and primitives themselves are a collection of geometric shapes. Three-dimensional model data is file data. When it is loaded in the three-dimensional CAD system, a three-dimensional model can be displayed in a virtual three-dimensional coordinate space. In this case, the file data is read out from the hard disk 5 into the main memory 4.

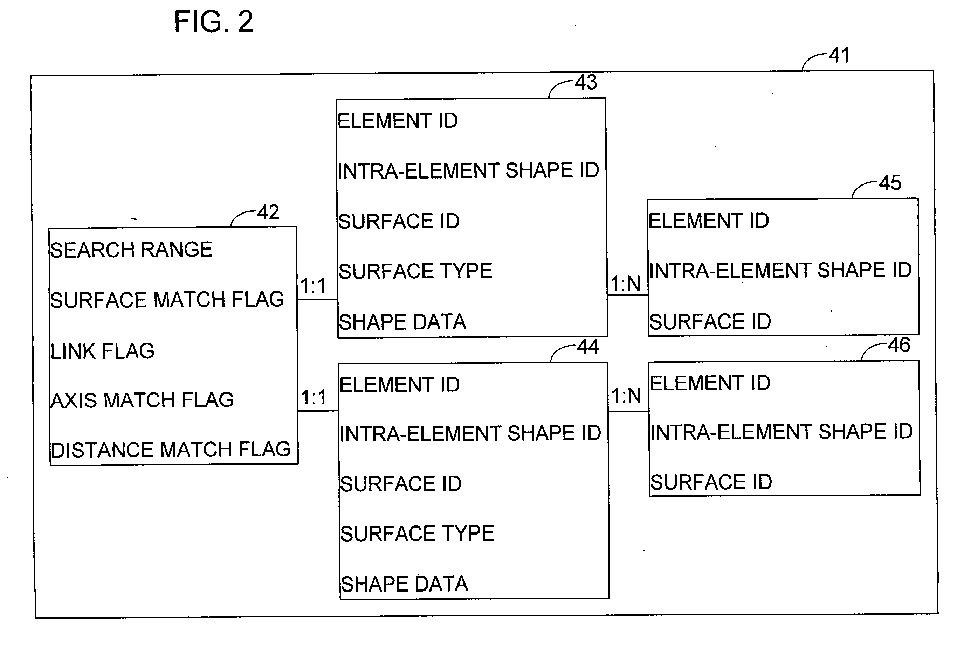

Fig. 2 is one example of a geometric-condition search table according to this embodiment. This example of a geometric-condition search table 41 includes a search-condition management part 42, a reference geometric data management part 43, a follow-up geometric data management part 44, a search data management part 45(46). When a user designates the target recognition function which is characteristic of the present invention, a geometric-condition search table 41 is formed in the main memory 4. The geometric-condition search table 41 is a table for automatically recognizing geometric shapes. The basic data structure can be implemented using data structures such as an array, a list, etc. Surface types and geometric data of surfaces can be retrieved from the three-dimensional model data (CAD data) loaded in the main memory by use of the element ID, the intra-element shape ID, and the surface ID.

The primary-geometric data extraction means 11 extracts primary geometric data from the three-dimensional model data in the main memory 4 with respect to a designated geometric shape. More specifically, using data for identifying the designated geometric shape, data necessary for the following processing is extracted from among data about the designated geometric shape of the three-dimensional model data and is then stored in the corresponding portion of the geometric-condition search table 41 in the main memory 4.

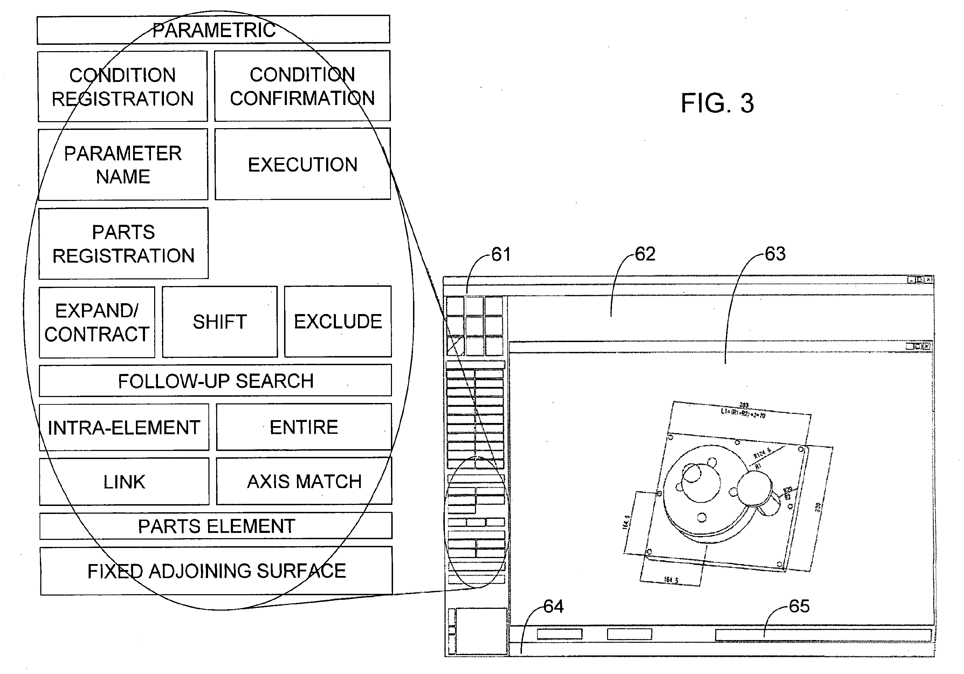

In addition to the portion in which the primary geometric data is stored, flags are set in the geometric-condition search table 41 by user's designation. The flags include surface match, link, axis match, and distance match. The surface match is selected by default. The states of the flags are changed by pressing the link button and the axis match button on the operating screen. Fig. 3 is one example of an operating window according to this embodiment. This example of an operating window includes a menu bar 61, a tool bar 62, a work window 63, a status bar 64, an edit bar 65.

The primary-geometric-condition determination means 12 refers to the geometric-condition search table 41 storing the primary geometric data to derive a geometric condition.

The automatic recognition means 13 detects a geometric shape that satisfies the geometric condition derived by the primary-geometric-condition determination means 12.

The secondary-geometric data extraction means 14 extracts secondary geometric data from the three-dimensional model data in the main memory 4 with respect to an additionally designated geometric shape. More specifically, using data for identifying the additionally designated geometric shape, data necessary for the following processing is extracted from among data about the designated geometric shape of the three-dimensional model data and is then stored in the corresponding portion of the geometric-condition search table 41 in the main memory 4.

The secondary-geometric-condition determination means 15 refers to the geometric-condition search table 41 storing the secondary geometric data to derive a geometric condition.

The automatic recognition means 13 detects a geometric shape that satisfies the geometric condition derived by the secondary-geometric-condition determination means 15.

In response to user's instruction to start up the system with a file of three-dimensional model data, the CAD normal means 20 reads the three-dimensional model data to display a three-dimensional model on the display means 2 and accepts an editing operation on the displayed three-dimensional model to apply a change to display of the three-dimensional model data or to the three-dimensional model itself according to the editing operation. The CAD normal means 20 is known art and can be implemented by those skilled in the art through appropriate design, and therefore, a detailed description thereof will be omitted here.

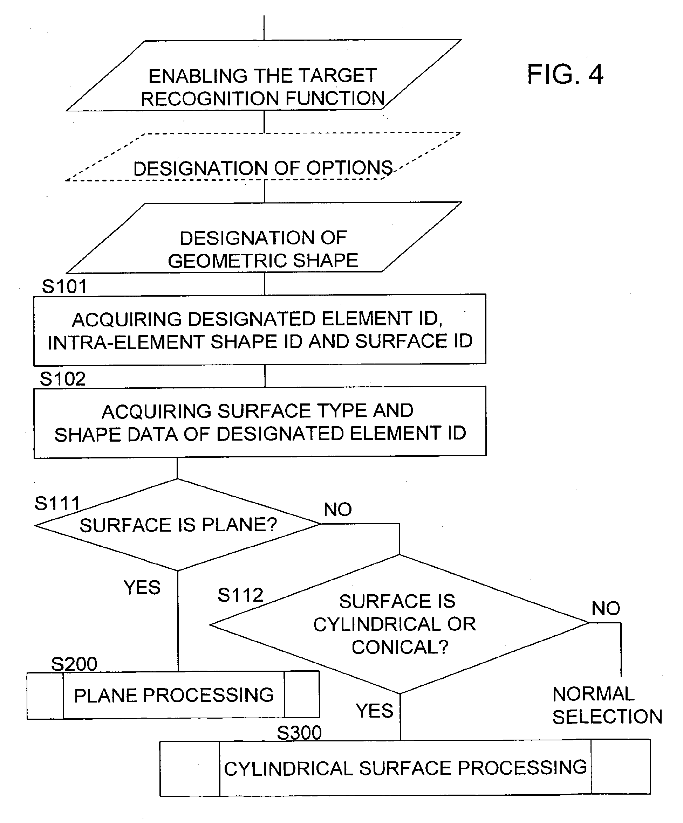

Fig. 4 is a flowchart illustrating one example of processing flow according to this embodiment. For processing in this embodiment, an actual process is triggered when the user presses the intra-element button or the entire button of Fig. 3 to enable the target recognition function and then presses, as required, the axis match button or the link button of Fig. 3 to designate a geometric shape. In short, the CAD normal means 20 identifies the designated geometric shape via an operating system (OS) in an event-driven manner in response to the event of a geometric shape being designated.

The primary-geometric data extraction means 11 acquires the element ID, the intra-element shape ID, and the surface ID for identifying the designated geometric shape and stores them in corresponding portions of the geometric-condition search table 41 (step 101). The primary-geometric data extraction means 11 acquires geometric data about the designated geometric shape from the model data loaded in the main memory and stores it in a corresponding portion of the geometric-condition search table 41 (step 102). In addition to the geometric data, the primary-geometric data extraction means 11 acquires data about the options designated by the user and sets flags in the geometric-condition search table 41 according the designated states of the options. The flag "surface match" for search-condition management part 42 in the geometric-condition search table 41 is set by default. The flag "surface match" is reset and the flag "link" is set by pressing the link button of Fig. 3. The flag for surface match is reset and the flag for axis match is set by pressing the axis match button of Fig. 3. The flag "surface match" is reset and the flags "link" and "axis match" are set by pressing both the link button and the axis match button. The flag "distance match" is enabled at the time of follow-up recognition because distance match cannot automatically recognize a geometric shape with only one geometric shape.

The primary-geometric-condition determination means 12 refers to the geometric-condition search table 41 to determine whether the designated geometric shape is a plane or not (step 111). When the primary-geometric-condition determination means 12 determines that it is a plane, the flow proceeds to plane processing as predefined processing (step 200). When the primary-geometric-condition determination means 12 determines that it is not a plane, it is determined whether the surface is a cylindrical surface or a conical surface (step 112). When the primary-geometric-condition determination means 12 determines that it is a cylindrical surface or a conical surface, the flow proceeds to cylindrical surface processing as predefined processing (step 300). When the primary-geometric-condition determination means 12 determines that it is not a cylindrical surface or a conical surface, normal selection results. Normal selection refers to selection with the target recognition function and the follow-up recognition function being disabled, in which only the designated geometric shape and an element or a sub-element including the geometric shape are selected. With normal selection, the processing proceeds to the CAD normal means 20.

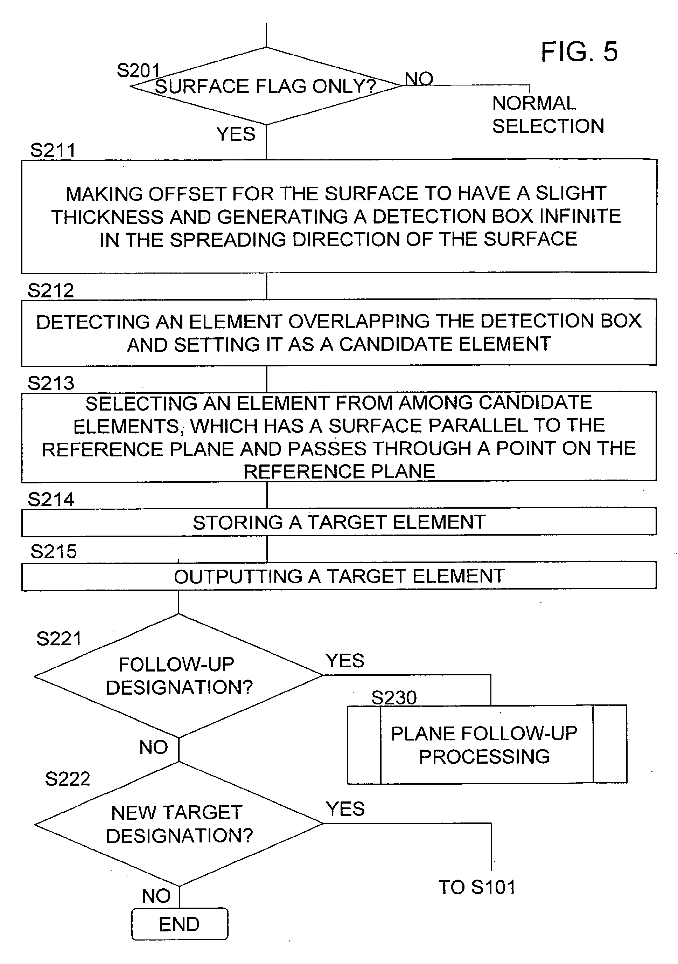

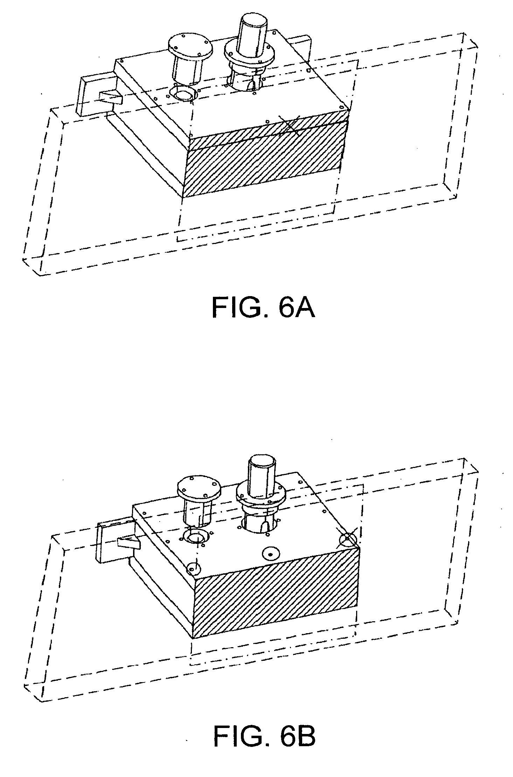

Plane processing (step 200, refer to Fig. 5) will now be described. The primary-geometric-condition determination means 12 determines whether only the surface match flag is set (step 201). When the primary-geometric-condition determination means 12 determines that a flag other than the surface flag is set, normal selection results. When the primary-geometric-condition determination means 12 determines that only the surface flag is set, the automatic recognition means 13 causes the designated surface to have a small thickness and virtually generates a detection box with an infinite length in the same direction as that of the surface (step 211). The rectangular parallelepiped formed by broken lines in Fig. 6A is an example of the detection box. It is noted, however, that for the sake of convenience in illustration, the detection box is not drawn as infinite in the same direction as that of the surface. The automatic recognition means 13 detects elements overlapping the generated detection box to set the detected elements as candidate elements (step 212). A technique for determining whether a solid object overlaps another solid object is well known and can be implemented by those skilled in the art through appropriate design, and therefore, a detailed description thereof will be omitted here. From among the candidate elements detected by the automatic recognition means 13, only elements having surfaces that are parallel to the designated surface and pass through a point on the designated surface are singled out (step 213). Here, all elements can be subjected to the processing in step 213 by skipping step 212. The automatic recognition means 13 stores the elements that have been singled out in step 213 in search data management part 45 associated with the reference geometric data management part 43 of the geometric-condition search table 41 (step 214). The automatic recognition means 13 passes the singled out elements to the CAD normal means 20 (step 215).

Subsequently to step 215, the processing proceeds to the CAD normal means 20, which displays the target elements including the designated element and the singled out elements on the display means 2 in a selected state. The user can perform editing operations, such as shifting, on the target elements being selected. As a display result of the above-described processing, for example, the case shown in Fig. 6A is applicable. This Fig. 6A shows that when the user designates the position indicated by x (cross) while the target recognition function is enabled, the processing from step 101 to step 215 is carried out to automatically select the geometric shape of the shaded area below.

Subsequently to step 215, the processing proceeds to the CAD normal means 20. When the user designates a geometric shape rather than, for example, an editing operation, the processing proceeds to the features of the present invention to determine whether there is a follow-up designation (step 221). Whether or not there is a follow-up designation depends on user's designation. This is because selection includes normal selection, selection by the target recognition function, and selection by the follow-up recognition function. For example, when the target recognition function ends and another geometric shape is designated subsequently, selection by the follow-up recognition function can result, and when the target recognition function ends and the intra-element button or the entire button is pressed again, selection by the target recognition function can result. When it is determined in step 221 that there is follow-up designation, the flow proceeds to plane follow-up processing, which is predefined processing (step 230). When it is determined in step 221 that there is no follow-up designation and it is determined in step 222 that there is a new target designation, the flow proceeds to step 101 with the newly designated geometric shape as a designated geometric shape.

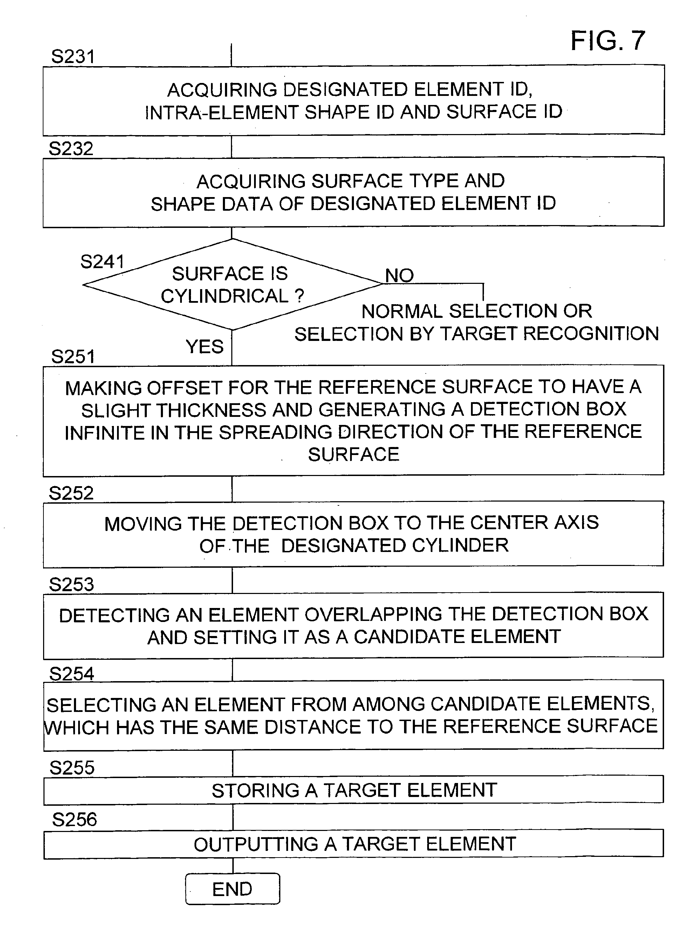

Plane follow-up processing (step 230, refer to Fig. 7) will now be described. First, the secondary-geometric data extraction means 14 acquires the element ID, the intra-element shape ID, and the surface ID for identifying the designated geometric shape and stores them in corresponding portions of the follow-up geometric data management part 44 of the geometric-condition search table 41 (step 231). The secondary-geometric data extraction means 14 acquires geometric data about the designated geometric shape from the model data loaded in the main memory 4 and stores it in a corresponding portion of the follow-up geometric data management part 44 of the geometric-condition search table 41 (step 232). In addition to the geometric data, the secondary-geometric data extraction means 14 acquires data about the options designated by the user and sets flags in the geometric-condition search table 41 according to the designated states of the options. The secondary-geometric-condition determination means 15 determines whether the designated geometric shape is a cylindrical surface (step 241). When the secondary-geometric-condition determination means 15 determines that it is not a cylindrical surface, normal selection or selection by target recognition is carried out. When the secondary-geometric-condition determination means 15 determines that it is a cylindrical surface, the automatic recognition means 13 sets the surface designated during target recognition as a reference surface and causes this reference surface to have a small thickness to virtually generate a detection box with an infinite length in the same direction as that of the reference surface (step 251). The automatic recognition means 13 moves the generated detection box to the center axis of the cylindrical surface that is the geometric shape newly designated during follow-up recognition (step 252). The rectangular parallelepiped formed by broken lines in Fig. 6B is an example of the moved detection box. It is noted, however, that for the sake of convenience in illustration, the detection box is not drawn as infinite in the same direction as that of the surface. The automatic recognition means 13 detects elements overlapping the moved detection box to set the detected elements as candidate elements (step 253). From among the candidate elements detected by the automatic recognition means 13, only elements having the same distance as the distance from the designated element to the reference surface are singled out (step 254). The automatic recognition means 13 stores the singled out elements in search data management part 46 associated with the follow-up geometric data management part 44 of the geometric-condition search table 41 (step 255). The automatic recognition means 13 passes the singled out elements to the CAD normal means 20 (step 256).

Subsequently to step 256, the processing proceeds to the CAD normal means 20, which displays the designated geometric shape, the geometric shape selected by the target recognition function, the additionally designated geometric shape, and the geometric shape selected by the follow-up recognition function on the display means 2 in a selected state. The user can perform editing operations, such as shifting, on the geometric shapes being selected. As a display result of the above-described processing, for example, the case shown in Fig. 6B is applicable. In this Fig. 6B, when the user designates the position indicated by x (cross) while the follow-up recognition function is enabled after the target recognition function has been executed, the processing from step 231 to step 256 is carried out to automatically select the circled holes other than the circle at the position indicated by x (cross).

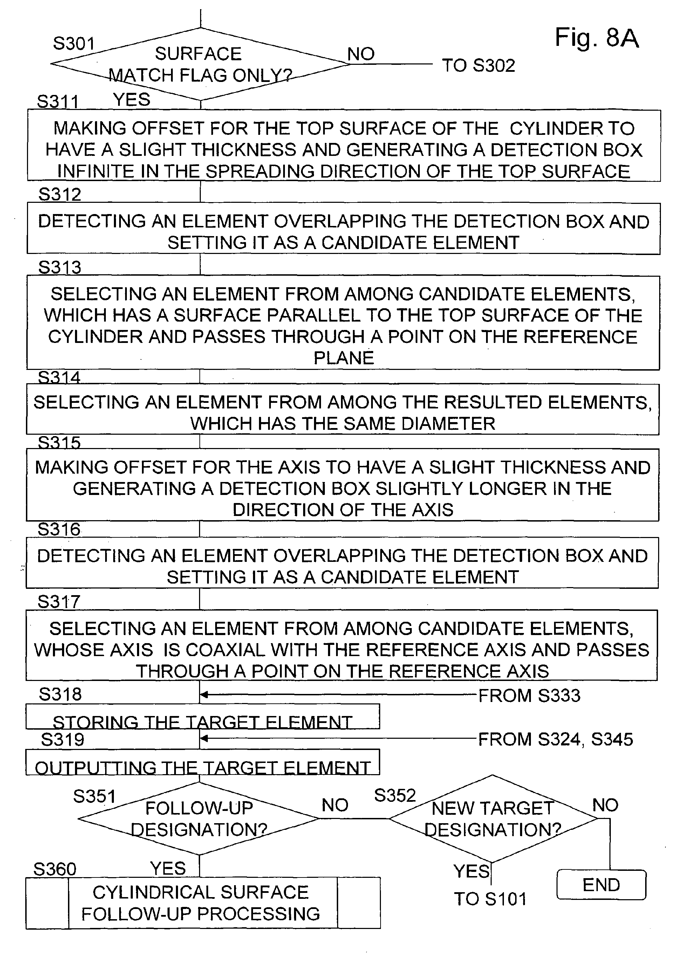

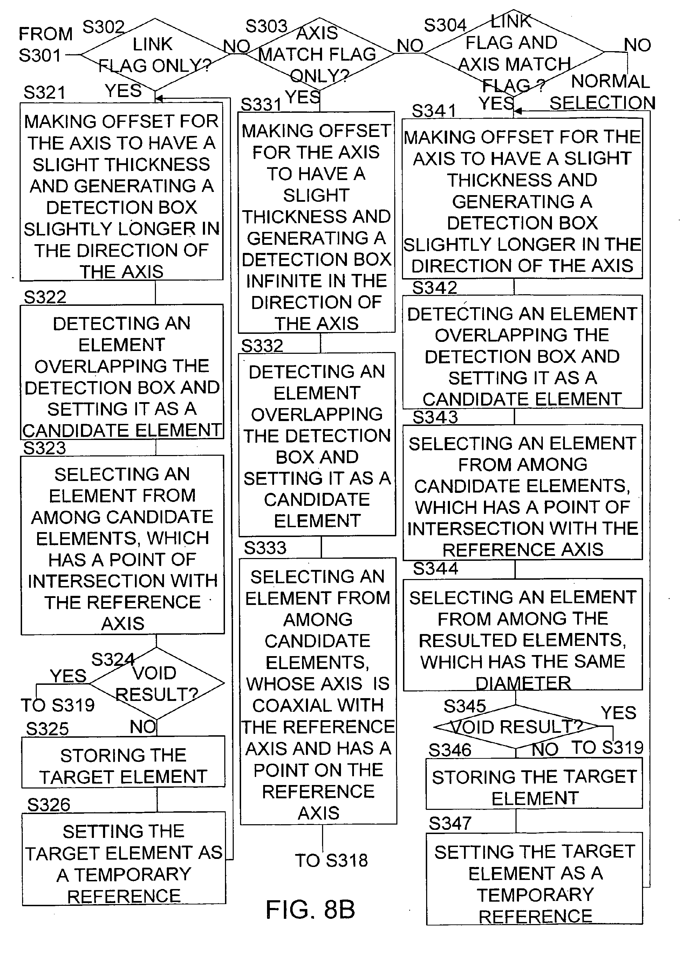

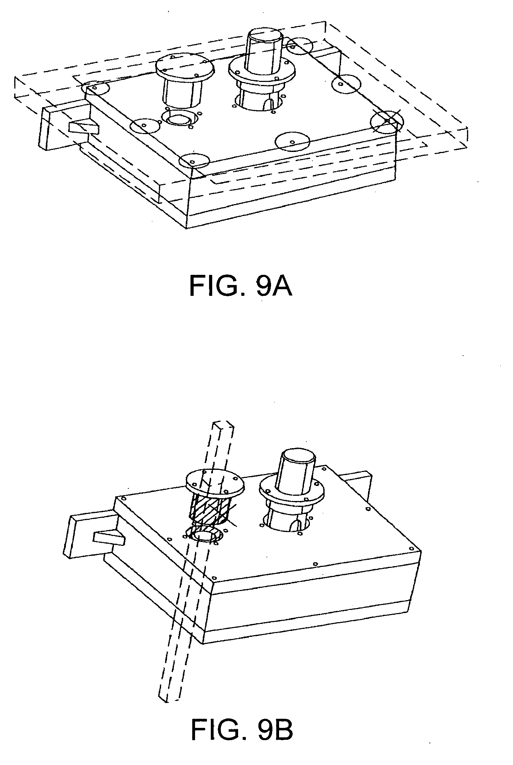

Cylindrical surface processing (step 300, refer to Figs. 8A and 8B) will now be described. The primary-geometric-condition determination means 12 determines whether only surface match is designated (step 301). When the primary-geometric-condition determination means 12 determines that only surface match is designated, it causes the top surface of the designated cylindrical surface to have a small thickness to virtually generate a detection box with an infinite length in the same direction as that of the top surface (step 311). The plate-shaped rectangular parallelepiped formed by broken lines in Fig. 9A is an example of the detection box. It is noted, however, that for the sake of convenience in illustration, the detection box is not drawn as infinite in the same direction as that of the surface. The automatic recognition means 13 detects elements overlapping the generated detection box to set the detected elements as candidate elements (step 312). From among the candidate elements detected by the automatic recognition means 13, only elements having surfaces that are parallel to the top surface of the cylinder and pass through the same point are singled out (step 313). Here, all elements can be subjected to the processing in step 313 by skipping step 312. From among the elements singled out in step 313, elements having the same diameter as that of the cylinder are selected (step 314). A detection box having a height along the center axis of the designated cylinder, the height being slightly larger than that of the designated cylinder, and having small longitudinal and lateral widths is virtually generated (step 315). The vertically elongated rod-like rectangular parallelepiped formed by broken lines in Fig. 9B is an example of the detection box. The automatic recognition means 13 detects elements overlapping the generated detection box to set the detected elements as candidate elements (step 316). From among the candidate elements detected by the automatic recognition means 13, only elements having center axes that are coaxial with the center axis of the designated cylinder and that pass through a point on the center axis of the designated cylinder are singled out (step 317). The automatic recognition means 13 stores the elements selected in step 314 and the elements singled out in step 317 in search data management part 45 associated with the reference geometric data management part 43 of the geometric-condition search table 41 (step 318). The automatic recognition means 13 passes the elements selected in step 314 and the elements singled out in step 317 to the CAD normal means 20 (step 319).

Subsequently to step 319, the processing proceeds to the CAD normal means 20, which displays the target elements including the selected element and the singled out elements on the display means 2 in a selected state. The user can perform editing operations, such as shifting, on the target elements being selected. As a display result of the above-described processing, for example, the cases shown in Figs. 9A and 9B are applicable. In this Fig. 9A, when the user designates the position indicated by x (cross) while the target recognition function is enabled, the processing from step 101 to step 319 is carried out to automatically select the circled holes other than the circle at the position indicated by x (cross). In this Fig. 9B, when the user designates the position indicated by x (cross) while the target recognition function is enabled, the processing from step 101 to step 319 is carried out to automatically select the hole in the shaded area other than the cylinder at the position indicated by x (cross).

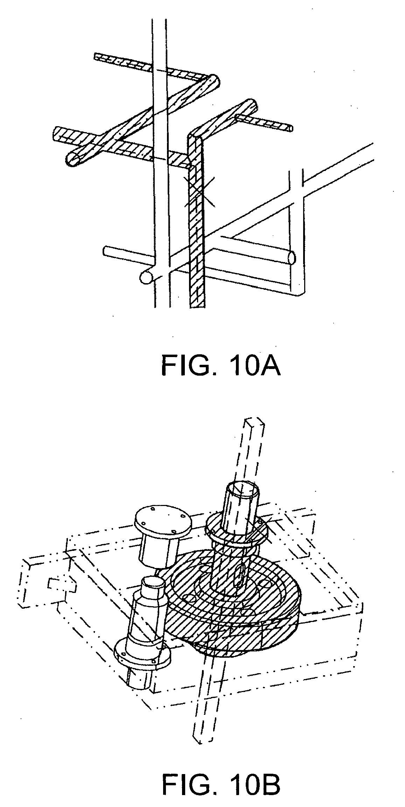

When the primary-geometric-condition determination means 12 determines in the above-described step 301 that not only surface match is designated, the primary-geometric-condition determination means 12 determines whether only the link is designated (step 302). When the primary-geometric-condition determination means 12 determines that only the link is designated, a detection box having a height along the center axis of the designated cylinder, the height being slightly larger than that of the designated cylinder, and having small longitudinal and lateral widths is virtually generated (step 321). Although no detection box is shown in Fig. 10A, the center axis of the vertically elongated tube at the position indicated by x (cross) is indicated by a dashed dotted line. The detection box contains this dashed dotted line. The automatic recognition means 13 detects elements overlapping the generated detection box to set the detected elements as candidate elements (step 322). From among the candidate elements detected by the automatic recognition means 13, only elements having a point of intersection with a line segment of the center axis of the cylinder are singled out (step 323). The automatic recognition means 13 determines whether there is an element singled out in step 323 (step 324). When the automatic recognition means 13 determines that there is no singled out element, the flow proceeds to step 319. When the automatic recognition means 13 determines that there is a singled out element, the element singled out in step 323 is stored in search data management part 45 of the geometric-condition search table 41 (step 325). The automatic recognition means 13 sets the element singled out in step 323 as a designated element (step 326), and the flow returns to step 321. By repeating the processing from step 321 to step 326 in this manner, elements linked to the designated element can be recognized one after another. Unlike the case where elements residing on the same surface are detected, elements linked to the designated element need to be detected first to find linked objects one after another.

Subsequently to step 319, the processing proceeds to the CAD normal means 20, which displays the target elements including the singled out elements on the display means 2 in a selected state. The user can perform editing operations, such as shifting, on the target elements being selected. As a display result of the above-described processing, for example, the case shown in Fig. 10A is applicable. This Fig. 10A shows that when the user designates the position indicated by x (cross) while the target recognition function is enabled, the processing from step 101 to step 319 is carried out to automatically select the linked geometric shapes in the shaded area.

When the primary-geometric-condition determination means 13 determines in the above-described step 302 that not only the link is designated, the primary-geometric-condition determination means 13 determines whether only the axis match is designated (step 303). When the primary-geometric-condition determination means 13 determines that only the axis match is designated, a detection box that has a height along the center axis of the designated cylinder, small longitudinal and lateral widths, and an infinite length in the axial direction is virtually generated (step 331). The vertically elongated rod-like rectangular parallelepiped formed by broken lines in Fig. 10B is an example of the detection box. It is noted, however, that for the sake of convenience in illustration, the detection box is not drawn as infinite in the axial direction. The automatic recognition means 13 detects elements overlapping the generated detection box to set the detected elements as candidate elements (step 332). From among the candidate elements detected by the automatic recognition means 13, only elements having center axes that have the same axial direction as the center axis of the designated cylinder and that pass through a point on the center axis of the designated cylinder are singled out (step 333), and the flow proceeds to step 318.

Subsequently to step 319, the processing proceeds to the CAD normal means 20, which displays the target elements including the designated element and the stored elements on the display means 2 in a selected state. The user can perform editing operations, such as shifting, on the target elements being selected. As a display result of the above-described processing, for example, the case shown in Fig. 10B is applicable. This Fig. 10B shows that when the user designates the position indicated by x (cross) while the target recognition function is enabled, the processing from step 101 to step 319 is carried out to automatically select the geometric shapes in the shaded area.

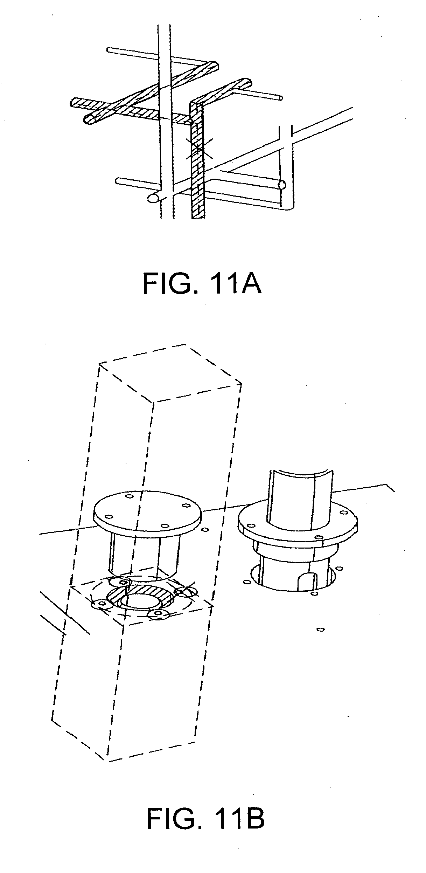

When the primary-geometric-condition determination means 13 determines in the above-described step 303 that not only the axis match is designated, the primary-geometric-condition determination means 13 determines whether only the link and axis match are designated (step 304). When the primary-geometric-condition determination means 13 determines that not only the link and the axis match are designated, normal selection results. When the primary-geometric-condition determination means 13 determines that only the link and axis match are designated, a detection box that has a height along the center axis of the designated cylinder, the height being slightly larger than the height of the designated cylinder, and small longitudinal and lateral widths is virtually generated (step 341). Although no detection box is shown in Fig. 11A, the center axis of the vertically elongated tube at the position indicated by x (cross) is indicated by a dashed dotted line. The detection box contains this dashed dotted line. The automatic recognition means 13 detects elements overlapping the generated detection box to set the detected elements as candidate elements (step 342). From among the candidate elements detected by the automatic recognition means 13, only elements having a point of intersection with a line segment of the center axis of the cylinder are singled out (step 343). Furthermore, from among the singled out elements, the automatic recognition means 13 selects elements having the same diameter as that of the designated element (step 344). The automatic recognition means 13 determines whether there is an element selected in step 344 (step 345). When the automatic recognition means 13 determines that there is no selected element, the flow proceeds to step 319. When the automatic recognition means 13 determines that there is a selected element, the element selected in step 344 is stored in search data management part 45 of the geometric-condition search table 41 (step 346). The automatic recognition means 13 sets the element selected in step 344 as a designated element (step 347), and the flow returns to step 341. By repeating the processing from step 341 to step 347 in this manner, elements that are linked to the designated element and that have coincident axes can be recognized one after another.

Subsequently to step 319, the processing proceeds to the CAD normal means 20, which displays the target elements including the designated element and the stored elements on the display means 2 in a selected state. The user can perform editing operations, such as shifting, on the target elements being selected. As a display result of the above-described processing, for example, the case shown in Fig. 11A is applicable. This Fig. 11A shows that when the user designates the position indicated by x (cross) while the target recognition function is enabled, the processing from step 101 to step 319 is carried out to automatically select the linked geometric shapes that have the same diameter in the shaded area.

Subsequently to step 319, the processing proceeds to the CAD normal means 20. When the user designates a geometric shape rather than, for example, an editing operation, the processing proceeds to the features of the present invention to determine whether there is a follow-up designation (step 351). Whether or not there is a follow-up designation depends on user's designation. This is because selection includes normal selection, selection by the target recognition function, and selection by the follow-up recognition function. When it is determined in step 351 that there is a follow-up designation, the flow proceeds to cylindrical surface follow-up processing, which is predefined processing (step 360). When it is determined in step 351 that there is no follow-up designation and it is determined in step 352 that there is a new target designation, the flow proceeds to step 101 with the newly designated geometric shape as a designated geometric shape.

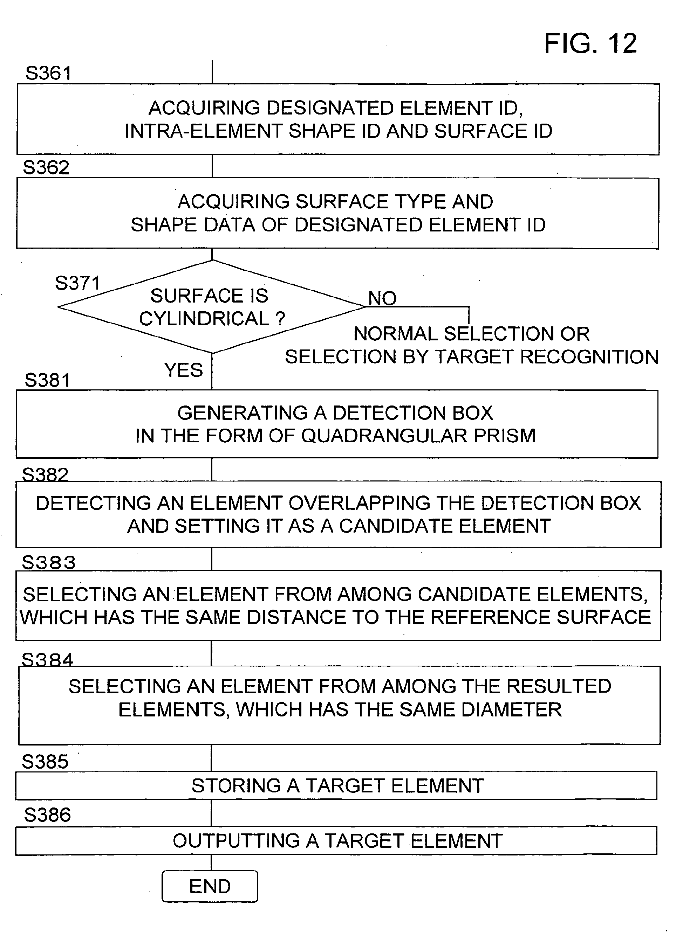

Cylindrical surface follow-up processing (step 360, refer to Fig. 12) will now be described. First, the secondary-geometric data extraction means 14 acquires the element ID, the intra-element shape ID, and the surface ID for identifying the designated geometric shape and stores them in corresponding portions of the follow-up geometric data management part 44 of the geometric-condition search table 41 (step 361). The secondary-geometric data extraction means 14 acquires geometric data about the designated geometric shape from the model data loaded in the main memory 4 and stores it in a corresponding portion of the follow-up geometric data management part 44 of the geometric-condition search table 41 (step 362). In addition to the geometric data, the secondary-geometric data extraction means 14 acquires data about the options designated by the user and sets flags in the geometric-condition search table 41 according the designated states of the options. The secondary-geometric-condition determination means 15 determines whether the designated geometric shape is a cylindrical surface (step 371). When the secondary-geometric-condition determination means 15 determines that it is not a cylindrical surface, selection by normal search or target recognition is carried out. When the secondary-geometric-condition determination means 15 determines that it is a cylindrical surface, the automatic recognition means 13 virtually generates a detection box in the form of a quadrangular prism surrounding a cylinder that has a radius equivalent to the maximum distance from the center of the cylinder designated during target recognition to the cylindrical surface designated during follow-up recognition and has a center equivalent to the center of the cylinder designated during target recognition (step 381). The vertically elongated rod-like rectangular parallelepiped formed by broken lines in Fig. 11B is an example of the detection box. The automatic recognition means 13 detects elements overlapping the generated detection box to set the detected elements as candidate elements (step 382). From among the candidate elements detected by the automatic recognition means 13, only elements having the same distance as the distance from the cylindrical surface designated during follow-up recognition to the cylindrical surface designated during target recognition are singled out (step 383). Furthermore, from among the singled out elements, the automatic recognition means 13 selects elements having the same diameters as that of the element designated during follow-up recognition (step 384). The automatic recognition means 13 stores the selected elements in search data management part 46 associated with the follow-up geometric data management part 44 of the geometric-condition search table 41 (step 385). The automatic recognition means 13 passes the singled out elements to the CAD normal means 20 (step 386).

Subsequently to step 386, the processing proceeds to the CAD normal means 20, which displays the designated geometric shape, the additionally designated geometric shape, and the geometric shape selected by the target recognition function and the geometric shape selected by the follow-up recognition function on the display means 2 in a selected state. The user can perform editing operations, such as shifting, on the geometric shapes being selected. As a display result of the above-described processing, for example, the case shown in Fig. 11B is applicable. This Fig. 11B shows that when the user designates the position indicated by x (cross) while the follow-up recognition function is enabled after the user performs designation with the target recognition function enabled, the processing from step 361 to step 386 is carried out to automatically select the circled holes that have the same distance from the reference surface and the same diameter.

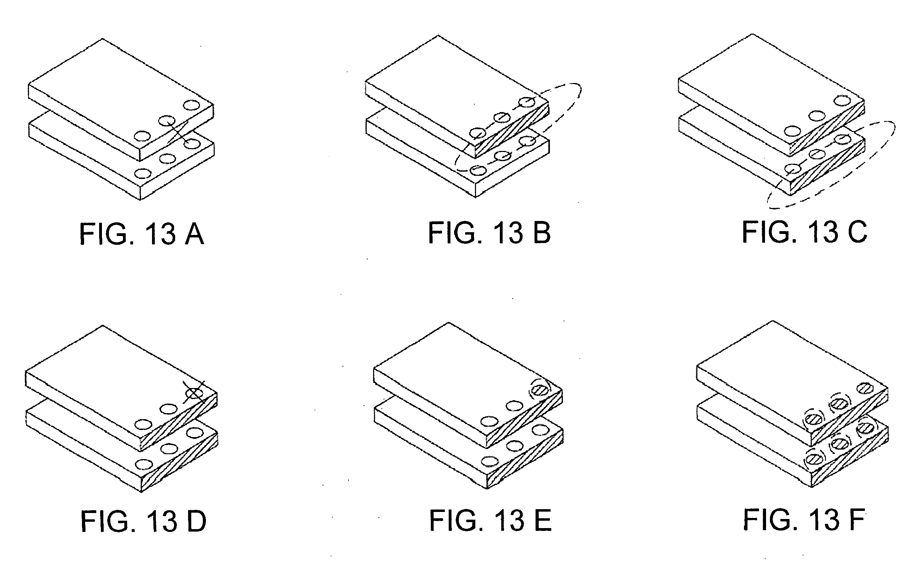

User's operation and system processing when the geometric shapes indicated by hatched lines, as shown in Fig. 13F, are selected will now be described. When the user designates the surface of the plate indicated by x (cross) (refer to Fig. 13A), the designated plane is recognized by the CAD normal means 20 and is then displayed on the display means 2 in a selected state (refer to Fig. 13B). Next, the flow proceeds via step 101 and step 102. Because it is a plane, the flow proceeds via step 201, step 211, step 212, step 213, step 214, and step 215. Then, the CAD normal means 20 displays on the display means 2 in a selected state the surface on the lower plate, which is the same plane as the designated plane (refer to Fig. 13C). Next, when the user designates the right hole on the plate indicated by x (cross) as follow-up designation (refer to Fig. 13D), the designated hole is recognized by the CAD normal means 20 and is displayed on the display means 2 in a selected state (refer to Fig. 13E). Because there is a follow-up designation, the flow proceeds via step 231, step 232, step 241, step 251, step 252, step 253, step 254, step 255, and step 256. Then, the CAD normal means 20 displays on the display means 2 in a selected state the cylindrical surfaces with the same distance as the distance between the surface designated in Fig. 13A and the cylindrical surface designated in Fig. 13D from the surface designated in Fig. 13A and the cylindrical surfaces with the same distance as the above-described distance from the surface automatically selected in Fig. 13C (refer to Fig. 13F).

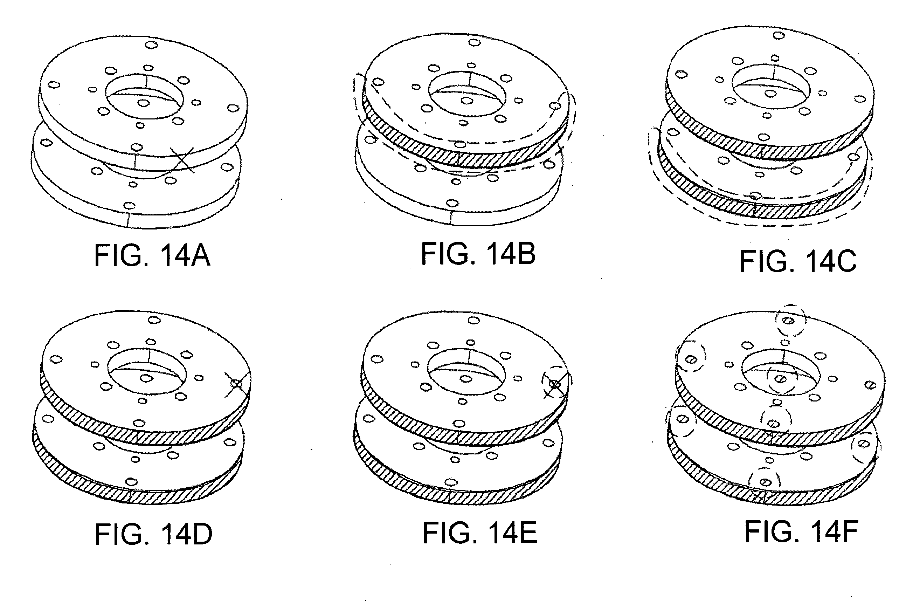

Next, user's operation and system processing when geometric shapes, as shown in Fig. 14F, are selected will now be described. When the user designates the cylindrical surface of the cored disc indicated by x (cross) (refer to Fig. 14A), the designated surface is recognized by the CAD normal means 20 and is then displayed on the display means 2 in a selected state (refer to Fig. 14B). Next, the flow proceeds via step 101 and step 102. Because it is a cylindrical surface, the flow proceeds to step 300, where because only the surface flag is designated by the user, the flow proceeds via step 301, step 311, step 312, step 313, step 314, step 315, step 316, step 317, step 318, and step 319. Then, the CAD normal means 20 displays on the display means 2 in a selected state the surface on the lower cored disc, which is the same surface as the cylindrical surface of the designated cored disc (refer to Fig. 14C). Next, when the user designates the right hole on the cored disc indicated by x (cross) as follow-up designation (refer to Fig. 14D), the designated hole is recognized by the CAD normal means 20 and is displayed on the display means 2 in a selected state (refer to Fig. 14E). Because there is a follow-up designation, the flow proceeds via step 361, step 362, step 371, step 381, step 382, step 383, step 384, step 385, and step 386. Then, the CAD normal means 20 displays on the display means 2 in a selected state the cylindrical surface with the same distance as the distance between the cylindrical surface designated in Fig. 14A and the cylindrical surface designated in Fig. 14D from the cylindrical surface designated in Fig. 14A and the cylindrical surface with the same distance as the above-described distance from the cylindrical surface automatically selected in Fig. 14C (refer to Fig. 14F).

As described above, according to the three-dimensional CAD system of this embodiment, the primary-geometric data extraction means 11 extracts primary geometric data from a designated geometric shape, the primary-geometric-condition determination means 12 derives a geometric condition from the primary geometric data, and the automatic recognition means 13 automatically recognizes elements that satisfy the derived geometric condition. In this manner, a series of processes of automatically extracting data from the geometric shape of the element that has been designated first, obtaining a geometric condition serving as a select condition, and selecting an element that satisfies the geometric condition is automatically carried out. Therefore, the user can designate desired elements without having to designate the desired elements one at a time using input means. This reduces workload imposed on the user. Furthermore, even in a case where elements not desired by the user are selected, the user can deselect the undesired elements from among many elements automatically selected. This also reduces workload onto the user.

### Change in Size of Detection Box in Relation to Intra-element or Entire Designation

In this embodiment, the user designates a selection range as "intra-element" or "entire". For "intra-element", a detection box can be set to a size within the element to perform selection by target recognition or selection by follow-up recognition in the designated element. For "entire", the detection box can be set within the size of the displayed working window to perform selection by target recognition or selection by follow-up recognition in elements currently displayed in the working window. Processing can be completed more quickly by applying more restriction to the detection box. Even within the size of the working window, it is not necessary to search the entire three-dimensional virtual space, and processing in a visible range results, leading to quick processing. The search range in search-condition management part 42 in the geometric-condition search table 41 shown in Fig. 2 stores identification numbers indicating "no search", "intra-element", and "in screen."

### Selection by Target recognition Function on Designating a Plurality of Geometric Shapes

In this embodiment, when a geometric condition is to be derived, a geometric condition is derived not only from geometric data of one geometric shape but also from geometric data of a plurality of geometric shapes. The user can designate a plurality of geometric shapes to derive a geometric condition from geometric data of the designated geometric shapes. The user can derive a geometric condition from correlation of a plurality of geometric shapes instead of deriving a geometric condition from a single geometric shape. Thus, a geometric shape can be selected in further consideration of user's intention for selection, thereby achieving selection of more appropriate geometric shapes by eliminating undesired geometric shapes. This allows geometric shapes envisaged by the user to be selected automatically and more appropriately.

### Second Embodiment of the Present Invention

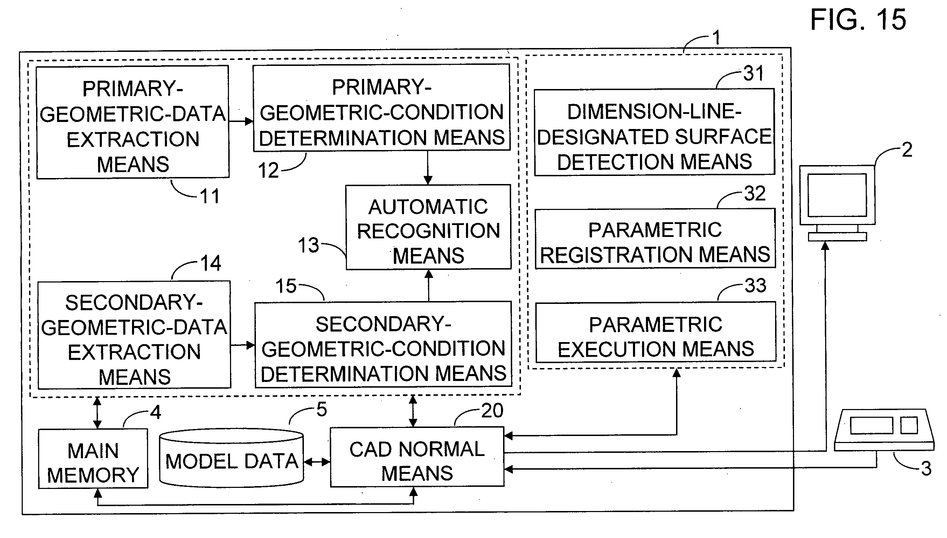

Another embodiment of the present invention will now be described with reference to the drawings. Fig. 15 is a block diagram showing the structure of a three-dimensional CAD system according to this embodiment. As shown in Fig. 15, the three-dimensional CAD system according to this embodiment has the same structure as in the above-described first embodiment, except that dimension-line-designated surface detection means 31 for detecting the geometric shape designated with a dimension line; parametric registration means 32 for registering parametric content designated by a user; and parametric execution means 33 for changing the parameter portion of the parametric content to perform parametric change are included.

Parametric modeling is available where a three-dimensional model is created by parameterizing not only shapes but also data for establishing shapes, such as distances, directions, connect conditions, and procedures for carrying out features, to change parameters as required. In this technique, geometric shapes and relationships between elements are pre-registered, and when an unexpected change occurs after a three-dimensional model once has been assembled, such geometric shapes and relationships between elements need to be reviewed to change parametric content as required. On the other hand, in this embodiment, geometric shapes and relationships between elements are not registered before a three-dimensional model is assembled. Instead, such geometric shapes and relationships between elements are registered, as required, after a three-dimensional model has been assembled (post-operational condition registration). By doing so, there are no constraints on geometric shapes and relationships between elements at the time when a three-dimensional model is assembled. A user can freely edit a geometric shape or an element, for example shifting, expansion/contraction, etc. In addition to a method of assembling a three-dimensional model without pre-registration, even a method of assembling a three-dimensional model while geometric shapes and relationships between elements are pre-registered can obtain data free from these relationships through data format conversion to achieve such constraint-free states.

Furthermore, in this embodiment, even after parametric content has been registered, geometric shapes and elements can be edited freely unless the user designates parametric execution. By doing so, there is not more constraint due to parametric content than necessary, and operation as the designer wishes is possible, thus leading to reduction in design time.

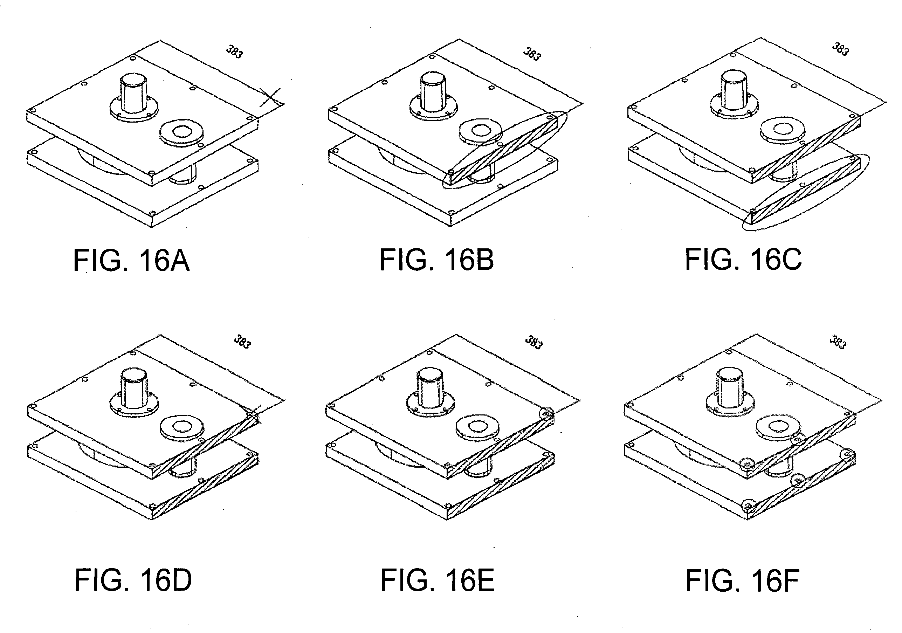

Processing of this embodiment will be described below. When the user presses the button for parametric registration shown in Fig. 3, the parametric registration means 32 displays on the display means 2 a window for allowing the user to input parametric content. Using the window here, geometric conditions (content, parameters) are defined. Furthermore, an object to which parametric registration is applied is designated. Although a surface as a geometric shape may be directly designated, the current description designates a dimension line for designating such a surface with the target recognition function enabled (refer to Fig. 16A). The dimension line includes a length dimension, an angular dimension, and a diameter dimension. For the length dimension and the angular dimension, two surfaces are designated normally. Which surface is intended by the user is determined according to the position designated by the user. In this embodiment, when there are upper and lower surfaces and there is a dimension line for designating these surfaces, the dimension-line-designated surface detection means 31 divides this dimension line into three segments for grasp. When the user designates the upper position of the dimension line, it is determined that the upper surface is designated. When the user designates the center position of the dimension line, it is determined that the upper surface and the lower surface are designated. When the user designates the lower position of the dimension line, it is determined that the lower surface is designated.

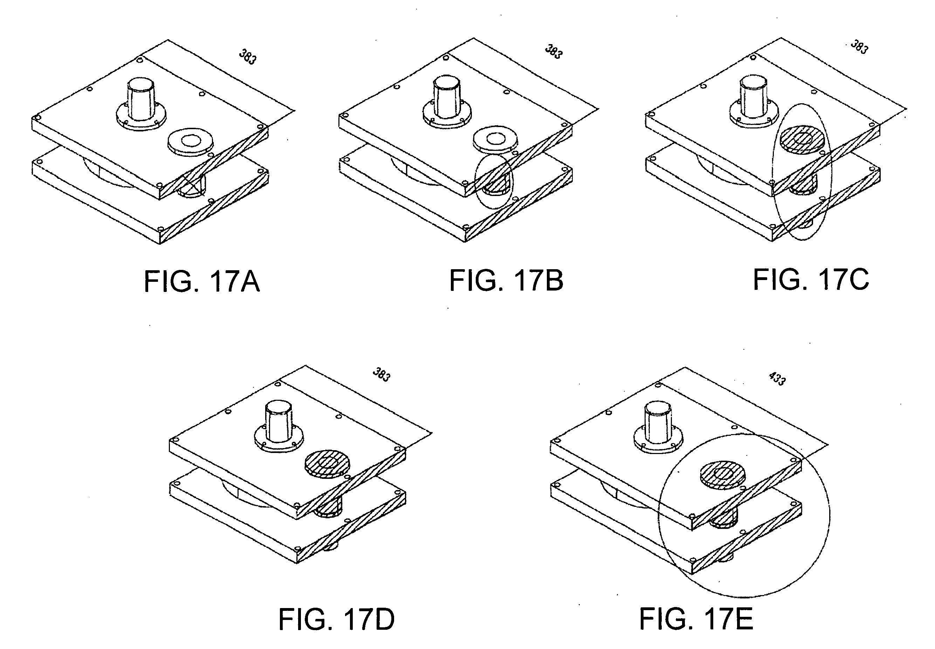

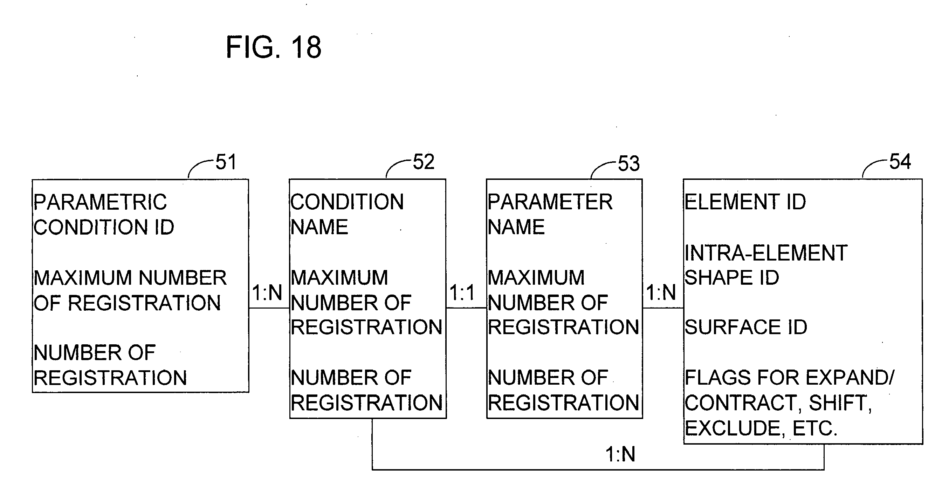

When a dimension line is designated as shown in Fig. 16A, the dimension-line-designated surface detection means 31 detects a surface of the upper plate, and it is displayed on the display means 2 as a designated surface in a selected state as indicated by hatched lines (refer to Fig. 16B). Target recognition is enabled, and processing for target recognition is carried out where the designated surface is a surface designated by the user. A surface, on the lower plate, that is on the same plane as the designated surface is displayed as a surface selected by target recognition on the display means 2 in a selected state, as shown by hatched lines (refer to Fig. 16C). Furthermore, when the user enables the follow-up recognition function and designates the right hole (cylindrical surface) on the upper plate (refer to Fig. 16D), the designated cylindrical surface is displayed on the display means 2 in a selected state as shown by hatched lines (refer to Fig. 16E). Processing for follow-up recognition is carried out, and the cylindrical surface that has the same distance as the distance between the surface designated first and the cylindrical surface designated during follow-up recognition from the surface designated first and the cylindrical surface that has the above-described same distance from the surface selected by the target recognition function are displayed on the display means 2 in a selected state as shown by hatched lines (refer to Fig. 16F). In addition, when the user designates axis match and designates a cylinder that passes through the upper plate and the lower plate while the target recognition function is still enabled (refer to Fig. 17A), the designated cylinder is displayed on the display means 2 in a selected state, as shown by hatched lines (refer to Fig. 17B). By carrying out processing for target recognition, a coaxial element is selected and displayed on the display means 2 in a selected state as shown by hatched lines (refer to Fig. 17C). By the user inputting parameter content on the parametric registration screen in this state, parameter content, for example, for maintaining the same distance from the surface designated during target recognition and from the surface that resides on the same plane as this surface and that is selected by the target recognition function is input. Normally, parametric registration indicating that one surface and another surface are on the same plane is carried out, and then separately, parametric registration for each cylindrical surface is carried out with the distance from the designated surface as a parameter. In this embodiment, however, a plurality of surfaces and cylindrical surfaces are selected all in one, and in the case of the same constraint, parametric registration is carried out together according to this selection. More specifically, in the example of Figs. 17D and 17E, parametric registration indicating that one plane and another plane are on the same plane and parametric registration indicating that the distance from a plane to a cylindrical surface is a fixed distance are carried out. An example of table structure used for parametric registration is as shown in Fig. 18. This example includes a condition management table 51, a condition definition table 52, parameter definition table 53 and follow-up data 54. Because one condition definition table 52 corresponds to one parametric registration, a plurality of items of follow-up data 54 corresponds to one parametric registration. This follow-up data 54 has attributes including element ID, intra-element shape ID, surface ID, and flags. Therefore, it has the same attributes as the search data management part 46 in the geometric-condition search table 41 shown in Fig. 2. By doing so, automatically selected geometric shapes can be used as constrained by parametric registration.

Next, when these parameter contents are designated and parametric execution is carried out, for example, the widths of the upper plate and the lower plate can be changed by the parameter execution means 33 while retaining the distance from the above-described surface to the cylindrical surface (refer to Figs. 17D and 17E). Here, when the widths of the upper plate and the lower plate are changed without parametric execution with parameter content designated, the widths of the plates are changed without retaining the distance from the above-described surface to the cylindrical surface, and editing flexibility is maintained.

As described above, in this embodiment, not only is an object to be constrained automatically selected by the above-described automatic recognition method, but also a geometric condition that holds with respect to the designated geometric shape and the automatically selected geometric shape is set as a parametric constraint. This reduces the workload of inputting a parametric constraint, as well as the workload of user's designating an object to be constrained.

A geometric condition is derived from the additionally designated geometric shape and the geometric shape designated first to automatically select a geometric shape that satisfies the geometric condition as an object to be constrained and to set the geometric condition itself as a constraint. Therefore, not only a geometric shape having a certain relationship with the designated geometric shape but also a geometric shape having a certain relationship with the additionally designated geometric shape is set as an object to be constrained with the geometric condition itself as a constraint. This allows parametric registration to be performed substantially automatically using more relationships as constraints.

As described above, in this embodiment, objects to which parametric registration is applied are selected using the target recognition function and the follow-up recognition function, and furthermore, a plurality of geometric shapes is associated with one parametric registration. Therefore, not only is the workload of user's designating objects reduced but also one item of parametric registration is sufficient. This eliminates the need for two or more items of parametric registration, leading to decrease in workload placed on the user.

### Application of Geometric Conditions as Constraints

In this embodiment, a method where constraints are input separately by a user has been described. A geometric condition is derived in the process of target recognition and follow-up recognition, and parametric registration can be performed with the geometric condition as a constraint in parametric registration. This saves the user from designating constraints. In addition, when there is a plurality of geometric conditions, they can be displayed so as to be selected, for example, in a pull-down menu, thereby reducing workload onto the user.

### Other Embodiments

### Automatic Selection in Area Designation

In the above-described embodiments, when a geometric shape is to be selected, "entire" or "intra-element" can be designated. Alternatively, the user can designate a rectangular area in the working window with a mouse to perform selection by target recognition and selection by follow-up recognition in that designated area. Although rectangular area designation is not possible in typical three-dimensional CAD, for example, rectangular selection is made possible on the screen of the working window to designate a rectangular area with an infinite depth.

### Restriction of Automatic Selection

In the above-described embodiments, the number of automatically selected geometric shapes is not restricted. It can be restricted to prevent the system from experiencing extreme load. Furthermore, when the number of detected geometric shapes exceeds a threshold value while the number of geometric shapes is restricted in this manner, automatic switching to another geometric condition can be performed when two or more applicable geometric conditions are available.

### Automatic Selection of Other than Geometric Shape

Although geometric shapes are objects to be selected in the above-described embodiments, what is designated by the user during target recognition or follow-up recognition is not limited to geometric shapes, and the above-described automatic recognition can be applied to any CAD object with respect to CAD objects that can be designated by the user, such as components of a geometric shape and CAD objects composed of a geometric shape. Graphical elements, primitives, elements, parts, units, and assemblies can be set as objects to be designated by a user, and graphical elements, primitives, elements, parts, units, and assemblies can be set as objects to be automatically selected. In this case, when graphical elements are designated by the user, graphical elements can be set as objects to be automatically selected. When primitives are designated by the user, primitives can be set as objects to be automatically selected. When elements are designated by the user, elements can be set as objects to be automatically selected. When parts are designated by the user, parts can be set as objects to be automatically selected. When units are designated by the user, units can be set as objects to be automatically selected. When assemblies are designated by the user, assemblies can be set as objects to be automatically selected. In short, automatic selection according to the hierarchical level of CAD objects can be realized.

### Surface Match, Axis match, Link, Distance Match

The above-described embodiments have been described by way of example of target recognition of surface match to a plane, follow-up recognition of distance match to a plane, target recognition of surface match to a cylindrical surface, target recognition of axis match to a cylindrical surface, target recognition of link to cylindrical surface, and follow-up recognition of distance match to a cylindrical surface. These are only examples, and other relationships can be applied to other geometric shapes.

Although the present invention has been described by way of the foregoing embodiments, the technical scope of the present invention is not limited to the scope described in these embodiments. Instead, various modifications and improvements can be applied to these embodiments. Embodiments subjected to such changes or improvements are also covered by the technical scope of the present invention. This is apparent also from the CLAIMS and the Means for Solving the Problems.

## Claims

1. A CAD method comprising:
a step of acquiring first geometric data of a first CAD object selected;
a step of acquiring a first geometric condition on a basis of the first geometric data; and
a step of acquiring a second CAD object, said second CAD object satisfying the first geometric condition with respect to the first CAD object.

2. The CAD method of claim 1 further comprising:
a step of acquiring second geometric data of a third CAD object selected;
a step of acquiring a second geometric condition on a basis of the first geometric data and the second geometric data; and
a step of acquiring a forth CAD object, said forth CAD object satisfying the second geometric condition with respect to the first CAD object, the second CAD object and the third CAD object.

3. The CAD method of claim 1 further comprising:
a step of acquiring a first parameter in a parametric modeling on a basis of the first geometric condition, said first parameter relating the first CAD object and the second CAD object.

4. The CAD method of claim 3 further comprising:
a step of acquiring second geometric data of a third CAD object selected;
a step of acquiring a second geometric condition on a basis of the first geometric data and the second geometric data;
a step of acquiring a forth CAD object, said forth CAD object satisfying the second geometric condition with respect to the first CAD object, the second CAD object and the third CAD object; and
a step of acquiring a second parameter in the parametric modeling on a basis of the second geometric condition, said second parameter relating the first CAD object, the second CAD object, the third CAD object and the forth CAD object.

5. The CAD method of claim 1 wherein the first CAD object and the second CAD object are geometric shapes.

6. The CAD method of claim 2 wherein the first CAD object, the second CAD object, the third CAD object and the forth CAD object are geometric shapes.

7. A CAD method comprising:
a step of acquiring first geometric data of a set of CAD objects selected;
a step of acquiring a first geometric condition on a basis of the first geometric data; and
a step of acquiring a second CAD object, said second CAD object satisfying the first geometric condition with respect to the set of CAD objects.

8. A CAD system comprising:
a means for acquiring first geometric data of a first CAD object selected;
a means for acquiring a first geometric condition on a basis of the first geometric data; and
a means for acquiring a second CAD object, said second CAD object satisfying the first geometric condition with respect to the first CAD object.

9. The CAD system of claim 8 further comprising:
a means for acquiring second geometric data of a third CAD object selected;
a means for acquiring a second geometric condition on a basis of the first geometric data and the second geometric data; and
a means for acquiring a forth CAD object, said forth CAD object satisfying the second geometric condition with respect to the first CAD object, the second CAD object and the third CAD object.

10. The CAD system of claim 8 further comprising:
a means for acquiring a first parameter in a parametric modeling on a basis of the first geometric condition, said first parameter relating the first CAD object and the second CAD object.

11. The CAD system of claim 10 further comprising:
a means for acquiring second geometric data of a third CAD object selected;
a means for acquiring a second geometric condition on a basis of the first geometric data and the second geometric data;
a means for acquiring a forth CAD object, said forth CAD object satisfying the second geometric condition with respect to the first CAD object, the second CAD object and the third CAD object; and
a means for acquiring a second parameter in the parametric modeling on a basis of the second geometric condition, said second parameter relating the first CAD object, the second CAD object, the third CAD object and the forth CAD object.

12. The CAD system of claim 8 wherein the first CAD object and the second CAD object are geometric shapes.

13. The CAD system of claim 9 wherein the first CAD object, the second CAD object, the third CAD object and the forth CAD object are geometric shapes.

14. A CAD system comprising:
a means for acquiring first geometric data of a set of CAD objects selected;
a means for acquiring a first geometric condition on a basis of the first geometric data; and
a means for acquiring a second CAD object, said second CAD object satisfying the first geometric condition with respect to the set of CAD objects.

15. A program storage medium readable by a computer, tangibly embodying a program of instructions executable by the computer to perform method steps of a CAD method, said CAD method comprising:
a step of acquiring first geometric data of a first CAD object selected;
a step of acquiring a first geometric condition on a basis of the first geometric data; and
a step of acquiring a second CAD object, said second CAD object satisfying the first geometric condition with respect to the first CAD object.

16. The program storage medium of claim 15, said CAD method further comprising:
a step of acquiring second geometric data of a third CAD object selected;
a step of acquiring a second geometric condition on a basis of the first geometric data and the second geometric data; and
a step of acquiring a forth CAD object, said forth CAD object satisfying the second geometric condition with respect to the first CAD object, the second CAD object and the third CAD object.

17. The program storage medium of claim 15, said CAD method further comprising:
a step of acquiring a first parameter in a parametric modeling on a basis of the first geometric condition, said first parameter relating the first CAD object and the second CAD object.

18. The program storage medium of claim 17, said CAD method further comprising:
a step of acquiring second geometric data of a third CAD object selected;
a step of acquiring a second geometric condition on a basis of the first geometric data and the second geometric data;
a step of acquiring a forth CAD object, said forth CAD object satisfying the second geometric condition with respect to the first CAD object, the second CAD object and the third CAD object; and
a step of acquiring a second parameter in the parametric modeling on a basis of the second geometric condition, said second parameter relating the first CAD object, the second CAD object, the third CAD object and the forth CAD object.

19. The program storage medium of claim 15 wherein the first CAD object and the second CAD object are geometric shapes.

20. The program storage medium of claim 16 wherein the first CAD object, the second CAD object, the third CAD object and the forth CAD object are geometric shapes.
